# EUROPEAN PATENT APPLICATION

(11) **EP 2 966 776 A1**
(43) Date of publication of application: **13.01.2016**
(21) Application number: 14759440.2
(22) Date of filing: 07.03.2014
(51) Int. Cl.: H03H 9/54, H03H 7/12, H01P 1/20

(54) **RADIO FREQUENCY FILTER**

(30) Priority: 08.03.2013 KR 20130025092
(71) Applicant: KMW Inc., Gyeonggi-do 445-813 (KR)
(72) Inventor: PARK, Nam-Shin, Hwaseong-si Gyeonggi-do 445-813 (KR)
(74) Representative: Müller Hoffmann & Partner
(86) International application number: PCT/KR2014/001909
(87) International publication number: WO 2014/137194

(57) **Abstract**

The present invention relates to a radio frequency filter comprising: a first filter unit for filtering a signal in a first frequency band, which is a basic frequency band; a second filter unit for filtering a signal in a second frequency band, which is an additional frequency band in addition to the basic frequency band; and a switching unit having a structure in which at least one resonance terminal among one or more resonance terminals constituting the second filter unit is connected to or blocked from a ground terminal so as to eliminate or maintain the resonance function of the relevant resonance terminal(s).

## Description

### Technical Field

The present invention relates to a radio frequency filter used in a wireless communication system and, more particularly, to a radio frequency filter for enabling filtering band expansion, which may be more useful when the radio frequency filter has a cavity structure like a cavity filter.

### Background Art

A radio frequency filter is particularly used for processing a wireless transmission/reception signal in a radio frequency filter wireless communication system having a cavity structure. Particularly, the radio frequency filter is representatively applied to a base station, a repeater, or the like especially in a mobile communication system.

A radio frequency filter having a cavity structure generally includes a plurality of accommodation spaces having a rectangular parallelepiped shape or the like, that is, a plurality of cavity structures through a metallic housing, and a dielectric resonance (DR) element or a resonance element having a metallic resonance rod is provided inside each cavity structure to generate resonance of high frequency waves. A radio frequency filter having a cavity structure forms one resonance terminal for each cavity, and generally has a multi-level structure in which a plurality of resonance terminals is sequentially connected to each other. Further, in the radio frequency filter having the cavity structure mentioned above, a cover for shielding an open surface of the corresponding cavity structure may be provided at an upper portion of the cavity structure, and a plurality of tuning screws and nuts for fixing the corresponding tuning screws may be installed on the cover, as a tuning structure for tuning a filtering characteristic of the corresponding radio frequency filter. An example of a radio frequency filter having a cavity structure is disclosed in Korean Application Publication No. 10-2004-100084 (entitled "Radio Frequency Filter" and published on December 2, 2004) (inventors: Jong-Gyu Park, Sang-Sik Park, and Seung-Taek Jeong) filed by the present applicant.

Meanwhile, recently, in order to reduce the saturation state of an available frequency band allocated for a mobile communication service, the allocation of a frequency band (e.g. 700MHz band) established for other service, for example, a broadcasting service has been considered. Further, a situation may occur in which one service provider absorbs and merges with another service provider and then should provide a service while integrally managing a frequency band which has been used by the another provider. In this case, a function capable of simultaneously processing an added frequency band as well as a currently processed frequency band is required for a base station system of a service provider.

However, in order to process a signal of a frequency band added to the existing base station systems, a worker needs to visit, by himself or herself, each of the existing installed base station systems and replace or tune each piece of equipment. Further, such a work would be not only difficult but also a significant burden in terms of the working hour and working cost.

Therefore, recently, at the time of an initial installation of a base station system, in consideration of a frequency band to be additionally processed thereafter, the number of cases where necessary equipment is additionally installed in advance, or operation performance of each piece of equipment is implemented is increasing. For example, an antenna radiating element may be configured as a broadband radiating element in consideration of a frequency band to be added thereafter (e.g. 700MHz) as well as a currently processed frequency band (e.g. 800MHz).

However, a radio frequency filter used in a base station system requires a very sensitive and excellent filtering characteristic in terms of the operation characteristic thereof, and has difficulty to obtain a satisfactory signal processing characteristic for each case mentioned above from a frequency band added to the existing frequency bands.

### Detailed Description of the Invention

### Technical Problem

Therefore, an aspect of the present invention is to provide a radio frequency filter which enables filtering band expansion, and is capable of favorably maintaining a filtering characteristic for each signal processing for the existing filtering band and a signal of a filtering band to be additionally expanded.

Another aspect of the present invention is to provide a radio frequency filter capable of reducing an installation coast and an installation space more efficiently, and having a structure enabling filtering band expansion.

### Technical Solution

In order to achieve the above-described aspects, the present invention includes: a first filter unit for filtering a signal of a first frequency band which is a basic frequency band; a second filter unit for filtering a signal of a second frequency band which is an additional frequency band added together with the basic frequency band; and a switching unit having a structure for connecting or blocking at least one resonance terminal from among resonance terminal(s) constituting the second filter unit to or from a ground terminal so as to eliminate or maintain the resonance function of the corresponding resonance terminal.

Hereinabove, the second filter unit is configured to have a structure in which a plurality of resonance terminals is sequentially connected to each other in a multi-stage, and the switching unit is configured to connect a second resonance terminal or a third resonance terminal to a ground terminal.

Hereinabove, the second filter unit has a cavity structure, and the switching unit includes: a switching terminal having a switching pin designed to be movable to be inserted into the interior of a cavity and to be drawn out to the outside of the cavity and electrically connected to a resonance element to connect the resonance element to a ground terminal when the switching pin is inserted into the interior of the cavity; and a driver for moving the switching pin by an exterior control signal.

Hereinabove, the resonance element may be a metal rod type resonance element, and the switching pin may be made of a metallic material, and have a structure which comes into direct contact with an upper end of the resonance element to connect the resonance element to the ground terminal when the switching pin is inserted into the interior of the cavity.

Hereinabove, the switching terminal further includes: an elastic body for providing restoring force to restore the switching pin to an initial location thereof; and a case for entirely surrounding and supporting the switching pin and the elastic body, wherein the case is coupled to and installed in a through hole arranged on a cover forming a part of the cavity.

Hereinabove, the resonance element may be a dielectric resonance element, and the switching pin may be made from ferrite and may be configured to be located close to an upper end of the resonance element to eliminate a resonance function when the switching pin is inserted into the interior of the cavity.

### Advantageous Effects

As described above, a radio frequency filter according to the present invention can favorably maintain a filtering characteristic for each signal processing for the existing filtering band and a signal of a filtering band to be additionally expanded, while enabling filtering band expansion. Further, the radio frequency can save installation costs and an installation space more efficiently.

### Brief Description of the Drawings

FIGs. 1A and 1B are block diagrams schematically illustrating a radio frequency filter according to embodiments of the present invention;
FIGs. 2A to 2C are views schematically illustrating internal structures of a radio frequency filter having a cavity structure according to embodiments of the present invention;
FIG. 3 is a circuit diagram illustrating a radio frequency filter according to a first embodiment of the present invention;
FIG. 4 is a waveform diagram illustrating a filtering characteristic at a time of operation according to one embodiment of FIG. 3;
FIG. 5 is a waveform diagram illustrating a filtering characteristic at a time of operation according to another embodiment of FIG. 3;
FIG. 6 is a circuit diagram illustrating a radio frequency filter according to a second embodiment of the present invention;
FIG. 7 is a waveform diagram illustrating a filtering characteristic at a time of operation according to one embodiment of FIG. 6;
FIG. 8 is a circuit diagram illustrating a radio frequency filter according to a third embodiment of the present invention;
FIG. 9 is a waveform diagram illustrating a filtering characteristic at a time of operation according to one embodiment of FIG. 8;
FIG. 10 is a circuit diagram illustrating a radio frequency filter according to a fourth embodiment of the present invention;
FIG. 11 is a waveform diagram illustrating a filtering characteristic at a time of operation according to one embodiment of FIG. 10;
FIG. 12 is a waveform diagram illustrating a filtering characteristic at a time of operation according to another embodiment of FIG. 10;
FIG. 13 is a circuit diagram illustrating a radio frequency filter according to a fifth embodiment of the present invention;
FIG. 14 is a waveform diagram illustrating a filtering characteristic at a time of operation according to one embodiment of FIG. 13;
FIG. 15 is a circuit diagram illustrating a radio frequency filter according to a sixth embodiment of the present invention;
FIG. 16 is a waveform diagram illustrating a filtering characteristic at a time of operation according to one embodiment of FIG. 15;
FIG. 17 is a circuit diagram illustrating a radio frequency filter experimentally implemented for comparing the present invention with embodiments;
FIG. 18 is a waveform diagram illustrating a filtering characteristic at a time of operation according to one embodiment of FIG. 17;
FIG. 19 is a waveform diagram illustrating a filtering characteristic at a time of operation according to another embodiment of FIG. 17;
FIG. 20 is a circuit diagram illustrating a radio frequency filter according to a seventh embodiment of the present invention;
FIG. 21 is a waveform diagram illustrating a filtering characteristic at a time of operation according to one embodiment of FIG. 20;
FIG. 22 is a waveform diagram illustrating a filtering characteristic at a time of operation according to another embodiment of FIG. 20;
FIG. 23 is a structure diagram illustrating a first example of a switching terminal which can be applied to a switching unit according embodiments of the present invention;
FIG. 24 is a structure diagram illustrating a first example of a driver for driving a switching terminal of FIG. 23, and main parts of a filter relating to the driver;
FIG. 25 is a structure diagram illustrating a second example of a driver for driving a switching terminal of FIG. 23, and main parts of a filter relating to the driver;
FIGs. 26A and 26B are structure diagrams illustrating a third example of a driver for driving a switching terminal of FIG. 23, and main parts of a filter relating to the driver; and
FIG. 27 is a structure diagram illustrating a second example of a switching terminal and main parts of a filter relating to the switching terminal, which may be applied to a switching unit according to embodiments of the present invention.

### Mode for Carrying Out the Invention

Hereinafter, exemplary embodiments of the present invention will be described in detail with reference to the accompanying drawings.

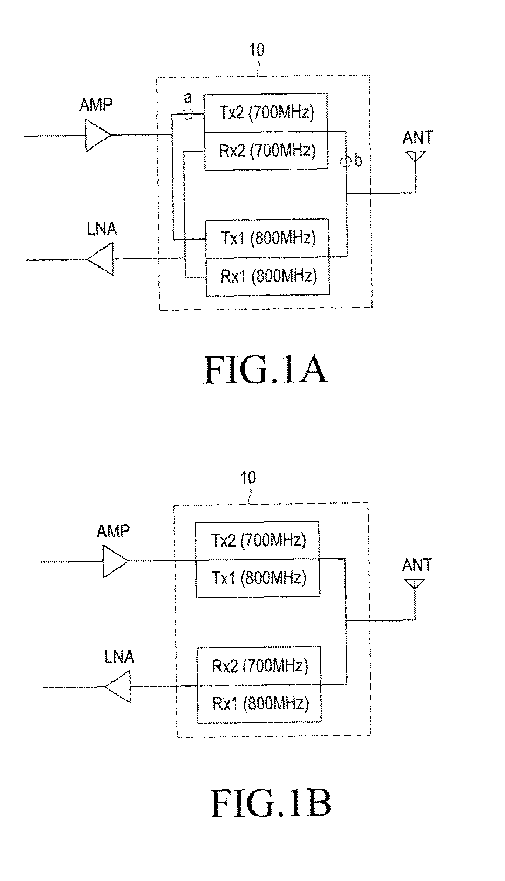

FIGs. 1A and 1B are block diagrams schematically illustrating a radio frequency filter according to embodiments of the present invention, and disclose, for example, a radio frequency filter which can be applied to a base station system. First, referring to FIG. 1A, a radio frequency filter 10 according to one embodiment of the present invention includes: first transmission and reception filter units Tx1 and Rx1 for filtering a signal of a first frequency band (e.g. 800MHz band), which is a basic frequency band; and second transmission and reception filter units Tx2 and Rx2 for filtering a signal of a second frequency band (e.g. 700MHz band) which is an additional frequency band added together with the basic frequency band, which is an additional frequency band. The radio frequency filter 10 illustrated in FIG. 1B has the same logical configuration as the radio frequency filter 10 illustrated in FIG. 1A, but is differently expressed to be more similar to an actual product structure.

In the base station system, a transmission signal is amplified by a high power AMPlifier (AMP) and is provided to the radio frequency filter 10. Thereafter, the transmission band of transmission signal is filtered and the transmission signal is then output to an antenna (ANT) side. Further, a signal received through the antenna ANT is provided to the radio frequency filter 10. Thereafter, the reception band of the signal is filtered and the signal is then provided to a Low Noise Amplifier (LNA) to be amplified.

In such a configuration, the radio frequency filter 10 may be basically configured to perform an operation of filtering only the transmission and reception signals of the first frequency band (at the time of initial installation). In this case, an internal path is configured to provide the transmission and reception signals to only the first transmission and reception filter units Tx1 and Rx2. In a use environment thereafter, when a signal processing of the second frequency band is additionally required, the radio frequency filter 10 is configured to perform an operation of filtering also the transmission and reception signals of the second frequency band together with a signal of the first frequency band. In this case, an internal path is configured to provide the transmission and reception signals to all of the first transmission and reception filter units Tx1 and Rx1, and the second transmission and reception filter units Tx2 and Rx2. Of course, the transmission signal and the reception signal are discriminated from each other. That is, the transmission signal is provided to the first and second transmission filter units Tx1 and Tx2 and the reception signal is provided to the first and second reception units Rx1 and Rx2. The signals filtered by the first and second transmission filters Tx1 and Tx2 are later coupled to each other and provided to the antenna ANT, and the signals filtered by the first and second reception filters Rx1 and Rx2 are later coupled to each other and provided to the LNA.

In the above-mentioned configuration, in order to configure a path such that the transmission and reception signals provided to the first transmission and reception filter units Tx1 and Rx1 are additionally provided to also the second transmission and reception filter units Tx2 and Rx2, a configuration having a switching unit (not illustrated) for connecting or blocking a signal path (a and b in FIG. 1A) connected to second transmission and reception filter units Tx2 and Rx2 sides by an exterior control signal may be primarily considered.

As an actual configuration of the switching unit, a motor switch structure operating in a solenoid driving scheme may be basically considered. However, a general switch structure mentioned above is not preferable in terms of securement of an installation space for additionally configuring the corresponding switching unit and installation costs. Further, it is not easy for a general switch structure (as will be mentioned below) to be implemented for a radio frequency filter for filtering a multi-band signal while the general switch structure actually has a cavity structure. Further, a switch structure (as will be mentioned below) for simply turning on/off a signal line has a bad influence on a filtering characteristic. The fact that a radio frequency filter which has a cavity structure and filters a signal of a multi-band is implemented in a filter combiner/divider scheme at the time of implementation of an actual product also serves as a significant factor of the bad influence.

That is, as illustrated in FIG. 1B, for example, the first and second transmission filter units Tx1 and Tx2 having cavity structures have individual housings, may be implemented to have a structure in which the two filter units are coupled to each other using a structure of a filter combiner/divider, which is similar to the structure of a duplexer, multiplexer, and the like, for non-loss coupling and distribution of a transmission signal, rather than having a structure in which separate input and output ports are formed and are then connected to each other. In this case, the structure of the filter combiner/divider has a structure in which signals which are input to one port P1 are respectively distributed from the interior of the filters to the first transmission filter unit Tx1 or the second transmission filter unit Tx2, are processed in the interior of a filter and then coupled in one port P2 again. As an example of a technology relating to such a filter combiner/divider, the technology is disclosed in Korean Patent Publication No. 10-2008-0114104, which is an application previously filed by the present applicant (entitled: "filter combiner/divider", inventors: Sang-Sik Park and Myeong-Hun Yang, and date of publication: December 31, 2008).

As described above, when the first and second transmission filters Tx1 and Tx2 are implemented by applying a filter combiner/divider structure, it can be understood that it is considerably difficult to install a switching unit having a switch structure of a general solenoid driving scheme, in a signal path connected to the second transmission filter unit Tx2 side.

In an embodiment of the present invention, when a switching unit is implemented, the switching unit is configured to have a structure for connecting or blocking at least one resonance terminal from among a plurality of resonance terminals constituting the second transmission filter unit Tx2 for filtering a second frequency band signal, which is an additional frequency band, to or from a ground terminal so as to eliminate or maintain the resonance function of the corresponding resonance terminal.

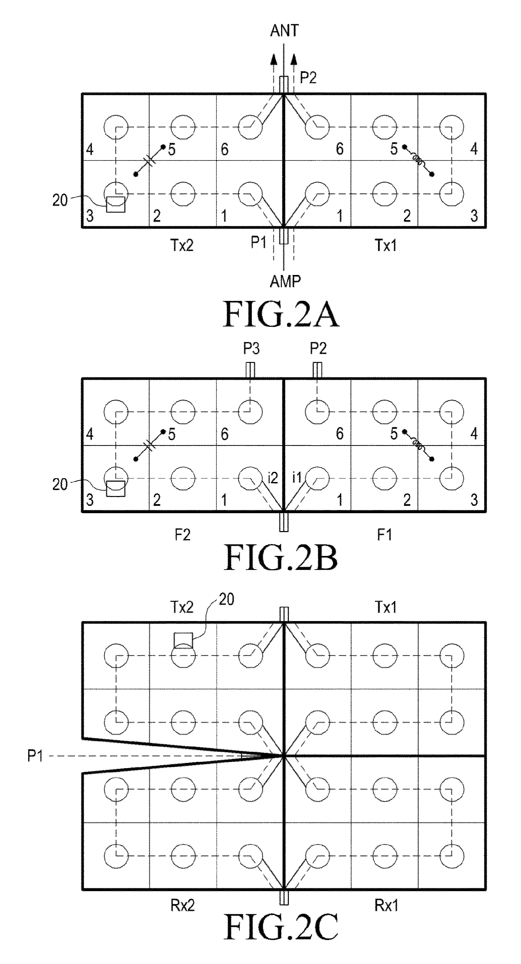

FIG. 2A to 2C are views schematically illustrating internal structures of a radio frequency filter having a cavity structure according to embodiments of the present invention, FIG. 2A shows a combiner type having two paths, FIG. 2B shows a duplexer type, and FIG. 2C shows a combiner type having four paths. First, referring to FIG. 2A, when only a structure of the first and second transmission filter units Tx1 and Tx2 are considered from among structures illustrated in FIG. 1B, a structure illustrated in FIG. 2A may similarly correspond to the structure of the first and second transmission filter units Tx1 and Tx2. In this case, the first and second transmission filter units Tx1 and Tx2 may have a structure in which a plurality of resonance terminals is sequentially connected. In such a structure, according to a characteristic of the present invention, a switching unit 20 may be configured to have a structure in which, for example, a third resonance terminal of the second transmission filter unit Tx2 eliminates or maintains the resonance function of the corresponding resonance terminal according to an exterior control signal. According to such a configuration, it may be configured by a switching operation of the switching unit 20 that only the first transmission filter unit Tx1 operates or both the first and second transmission filter units Tx1 and Tx2 operate.

The filter combiner/divider type structure illustrated in FIG. 2A may have, for example, a structure in which input lines i1 and i2, which are coupled to first resonance terminals (resonance elements of a resonance terminal) of the first and second transmission filter units Tx1 and Tx2, respectively, are commonly connected in one input port P1, wherein the lengths of the input lines i1 and i2 are precisely designed in consideration of the wavelength of a corresponding filtering frequency. Meanwhile, Korean Patent Publication No. 10-2008-0114104 as described above discloses a structure in which the input port P1 is connected to one common resonance terminal commonly used with the first resonance terminals of the two filter units mentioned above.

Referring to FIG. 2B, a structure illustrated in FIG. 2B is a structure in which first and second filter units F1 and F2 are coupled as a duplexer type. For example, signals which are input to a first port P1 are respectively distributed into the first and second filter units F1 and F2, the signals which have passed through the first filter unit F1 are output to the second port P2, and the signals which have passed through the second filter unit F2 are output to a third port P3. In such a structure, according to a characteristic of the present invention, a switching unit 20 may be configured to have a structure in which, for example, a third resonance terminal of the second filter unit F2 eliminates or maintains the resonance function of the corresponding resonance terminal according to an exterior control signal.

Referring to FIG. 2C, a structure illustrated in FIG. 2A may similarly correspond to an entire filter structure illustrated in FIG. 1B. In such a structure, according to a characteristic of the present invention, for example, the switching unit 20 may be configured in a second resonance terminal of the second transmission filter unit Tx2.

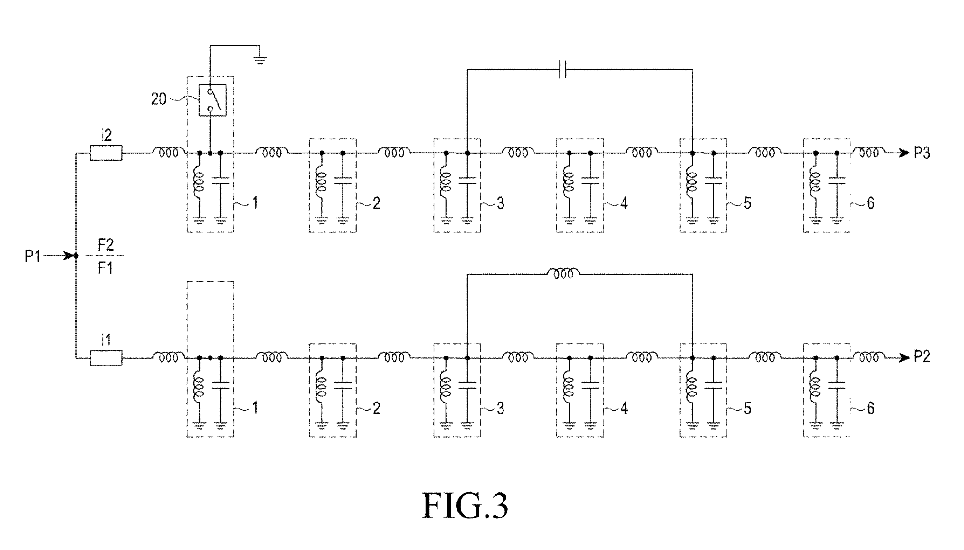

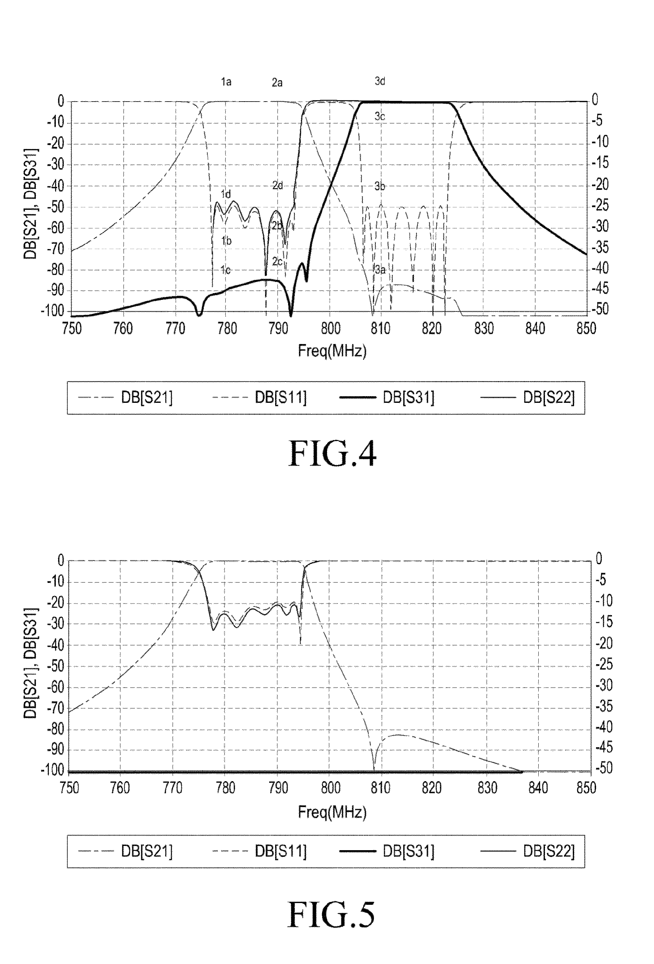

FIG. 3 is a circuit diagram illustrating a radio frequency filter according to a first embodiment of the present invention, FIG. 4 is a waveform diagram illustrating a filtering characteristic at the time of operation according to one embodiment of FIG. 3 and shows a waveform when a switching operation of the switching unit 20 is in an off state, and FIG. 5 is a waveform diagram illustrating a filtering characteristic at the time of operation according to another embodiment of FIG. 3 and shows a waveform when a switching operation of the switching unit 20 is in an on state. Referring to FIG. 3, a circuit of a radio frequency filter illustrated in FIG. 3, for example, may be a circuit similarly corresponding to a structure of a duplexer type illustrated in FIG. 2B. Unlike a structure illustrated in FIG. 2B, FIG. 3 illustrates a structure in which the switching unit 20 is formed in a first resonance terminal.

That is, in a radio frequency filter, each of the first filter unit F1 and the second filter unit F2 may be expressed as a circuit to which a plurality of resonance terminals (e.g. six resonance terminals) is sequentially connected, and a coupling between each of LC resonance terminals denotes by L. In this case, a first LC resonance terminal has a structure which can be connected to a ground terminal through the switching unit 20.

Hereinabove, the center frequency of the passband of the first filter unit F1 may be designed to be about 810-820 MHz, and the center frequency of the passband of the second filter unit F2 is designed to be about 780-790 MHz. In this case, as illustrated in FIG. 4, it can be understood that the first filter unit F1 and the second filter unit F2 normally operate when the switching unit 20 is in an off state. Unlike the above, as illustrated in FIG. 5, it can be understood that the second filter unit F2 does not operate and the first filter unit F1 only operates when the switching unit 20 is in an on state. In this case, it can be just understood that a filtering characteristic is slightly bad.

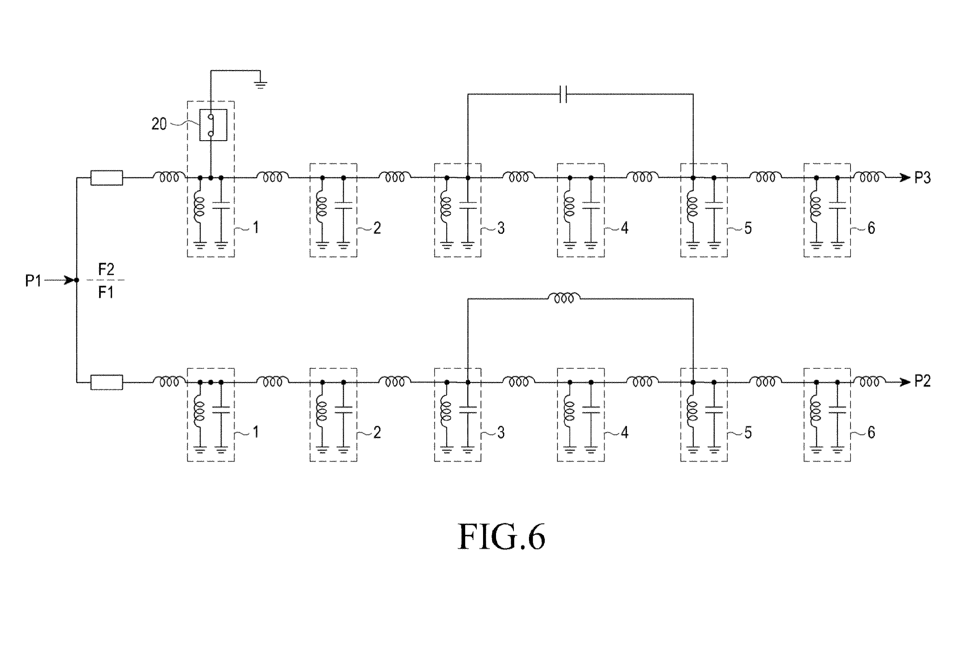

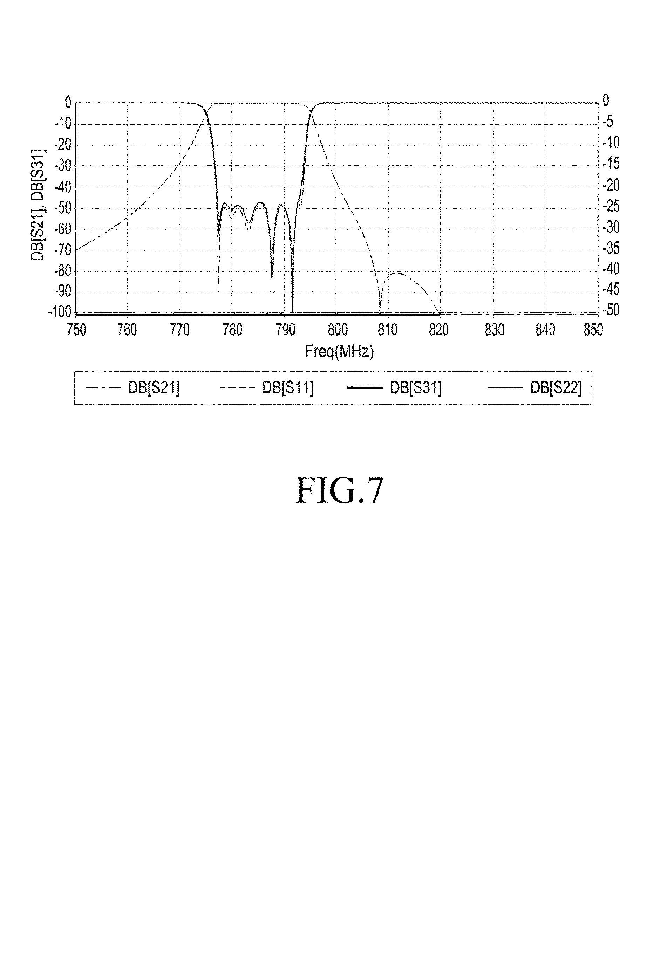

FIG. 6 is a circuit diagram illustrating a radio frequency filter according to a second embodiment of the present invention, and FIG. 7 is a waveform diagram illustrating a filtering characteristic at the time of operation according one embodiment of the present invention and shows a waveform when a switching operation of the switching unit 20 is in an on state. Referring FIGs. 6 and 7, a circuit of a radio frequency filter illustrated in FIG. 6 is identical to a circuit illustrated in FIG. 3, but a structure in which the switching unit 20 is formed in a second resonance terminal is illustrated unlike an embodiment of FIG. 3. In this case, it can be understood that a filtering characteristic is relatively good.

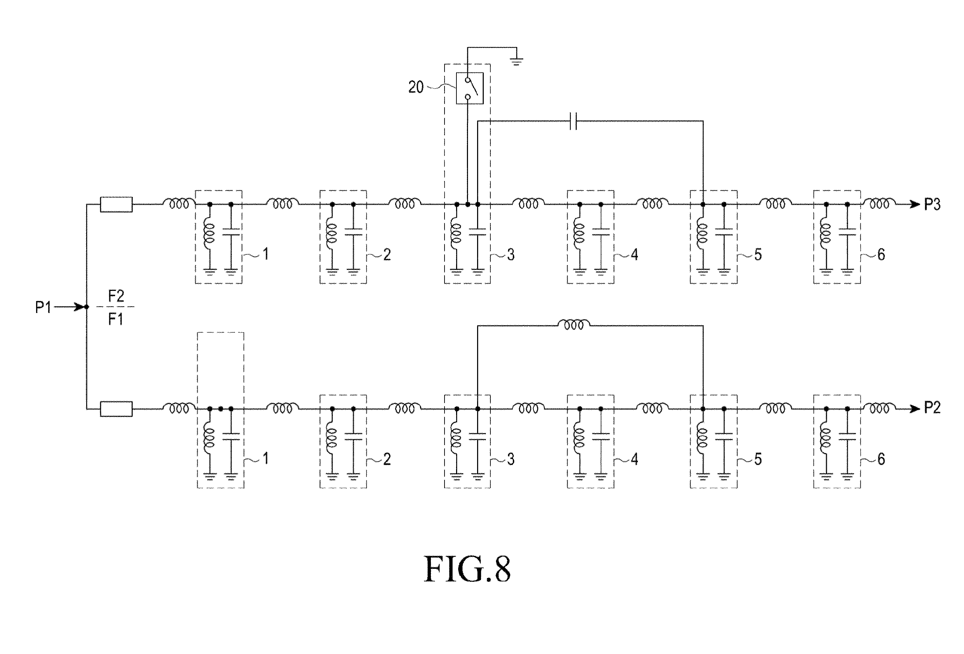

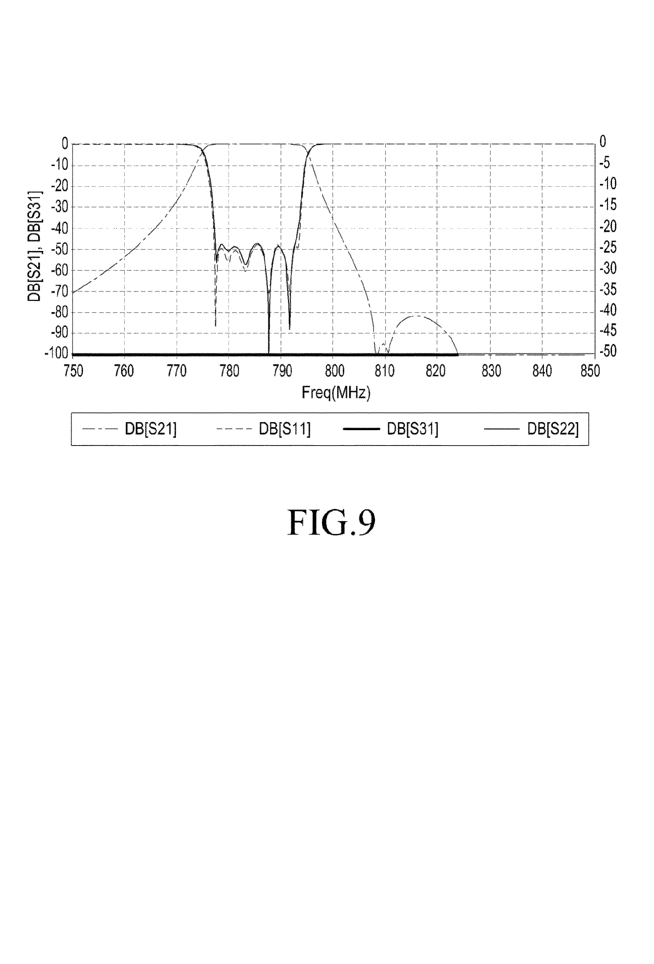

FIG. 8 is a circuit diagram illustrating a radio frequency filter according to a third embodiment of the present invention, and FIG. 9 is a waveform diagram illustrating a filtering characteristic at the time of operation according one embodiment of the present invention and shows a waveform when a switching operation of the switching unit 20 is in an on state. Referring FIGs. 8 and 9, a circuit of a radio frequency filter illustrated in FIG. 8 is identical to a circuit illustrated in FIGs. 3 and 6, but a structure in which the switching unit 20 is formed in a third resonance terminal is illustrated unlike embodiments of FIGs. 3 and 6. In this case, like when a structure having the first filter unit F1 coupled to the second filter unit F2 but a structure having only the first filter unit is provided, it can be understood that a filtering characteristic is very good.

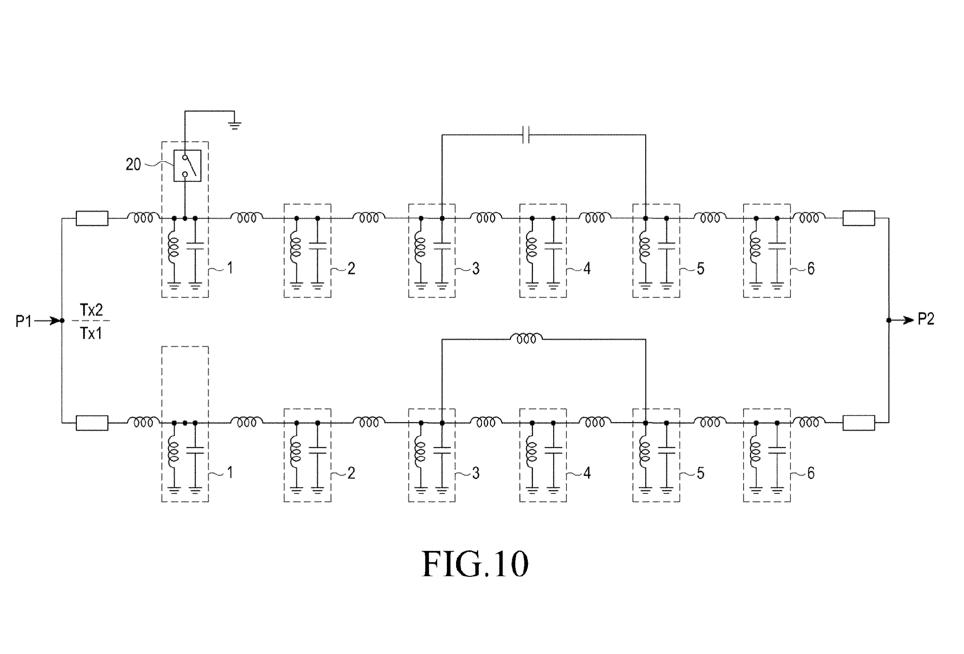

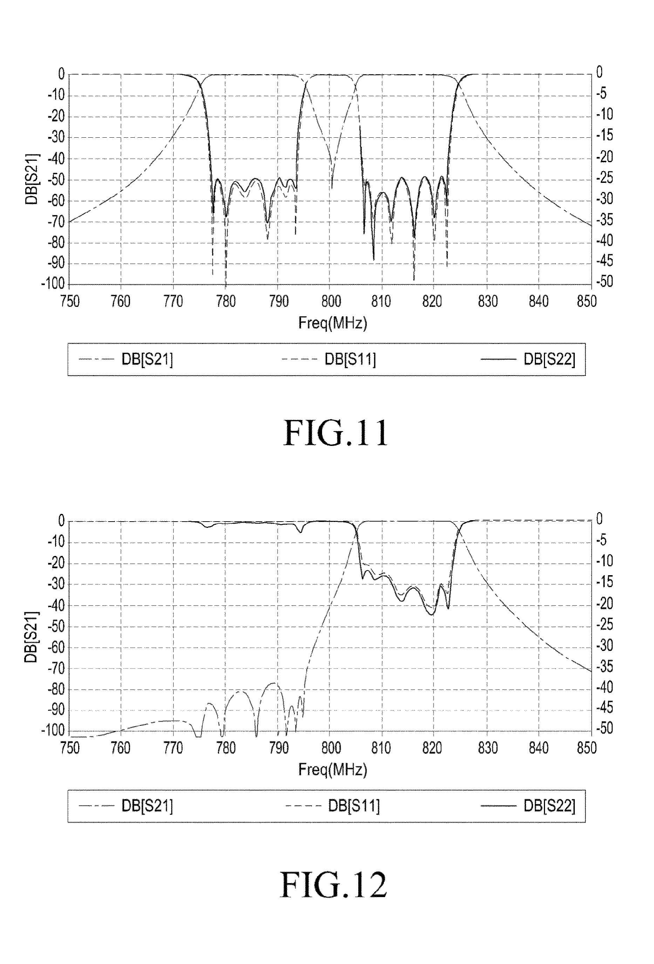

FIG. 10 is a circuit diagram illustrating a radio frequency filter according to a fourth embodiment of the present invention, FIG. 11 is a waveform diagram illustrating a filtering characteristic at the time of operation according to one embodiment of FIG. 10 and shows a waveform when a switching operation of the switching unit 20 is in an off state, and FIG. 12 is a waveform diagram illustrating a filtering characteristic at the time of operation according to another embodiment of FIG. 10 and shows a waveform when a switching operation of the switching unit 20 is in an on state. Referring to FIG. 10, a circuit of a radio frequency filter illustrated in FIG. 10, for example, may be a circuit similarly corresponding to a structure of a combiner type illustrated in FIG. 2A. Unlike a structure illustrated in FIG. 2A, FIG. 10 illustrates a structure in which the switching unit 20 is formed in a first resonance terminal.

That is, in a radio frequency filter, each of the first transmission filter unit Tx1 and the second transmission filter unit Tx2 may be expressed as a circuit in which a plurality of the LC resonance terminals (e.g. six LC resonance terminals) may be sequentially connected. In this case, the radio frequency filter has a structure in which a first LC resonance terminal may be connected to a ground terminal through the switching unit 20.

Hereinabove, the center frequency of the passband of the first filter unit F1 may be designed to be about 780-790 MHz, and the center frequency of the passband of the second filter unit F2 is designed to be about 810-820 MHz. In this case, as illustrated in FIG. 11, it can be understood that the first filter unit F1 and the second filter unit F2 normally operate when the switching unit 20 is in an off state. Unlike the above, as illustrated in FIG. 12, it can be understood that the second filter unit F2 does not operate and the first filter unit F1 only operates when the switching unit 20 is in an on state. In this case, it can be just understood that a filtering characteristic is slightly bad.

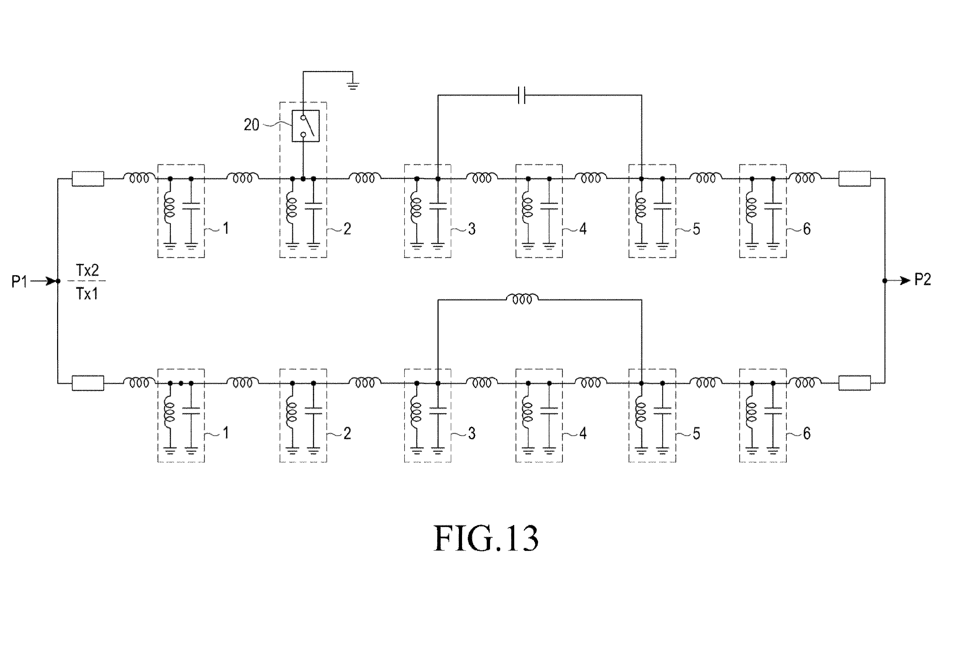

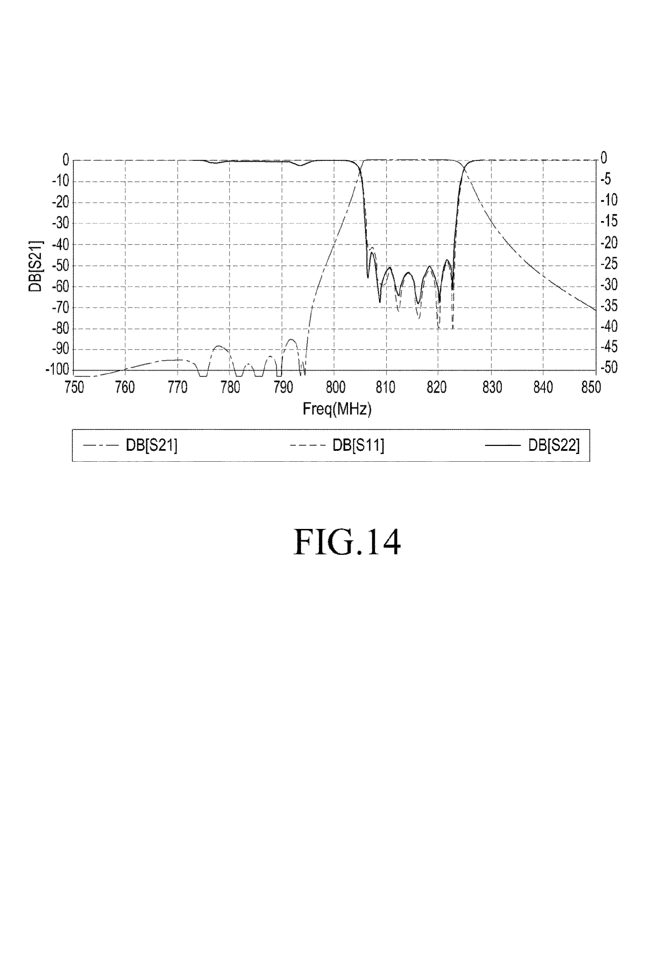

FIG. 13 is a circuit diagram illustrating a radio frequency filter according to a fifth embodiment of the present invention, and FIG. 14 is a waveform diagram illustrating a filtering characteristic at the time of operation according to one embodiment of the present invention and shows a waveform when a switching operation of the switching unit 20 is in an on state. Referring FIGs. 13 and 14, a circuit of a radio frequency filter illustrated in FIG. 13 is identical to a circuit illustrated in FIG. 11, but a structure in which the switching unit 20 is formed in a second resonance terminal is illustrated unlike an embodiment of FIG. 11. In this case, it can be understood that a filtering characteristic becomes slightly good compared to an embodiment of FIG. 11.

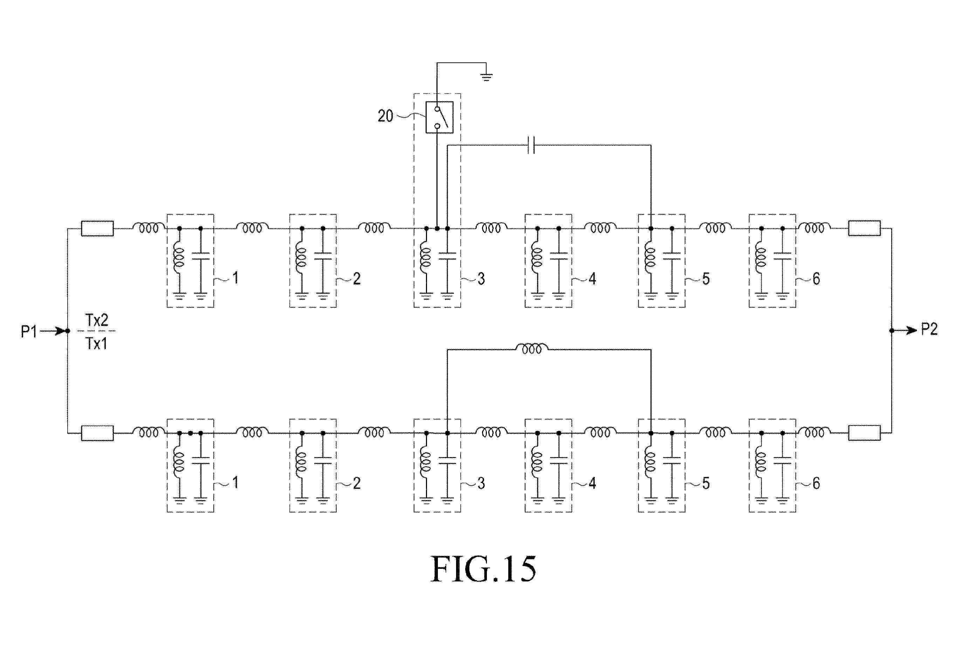

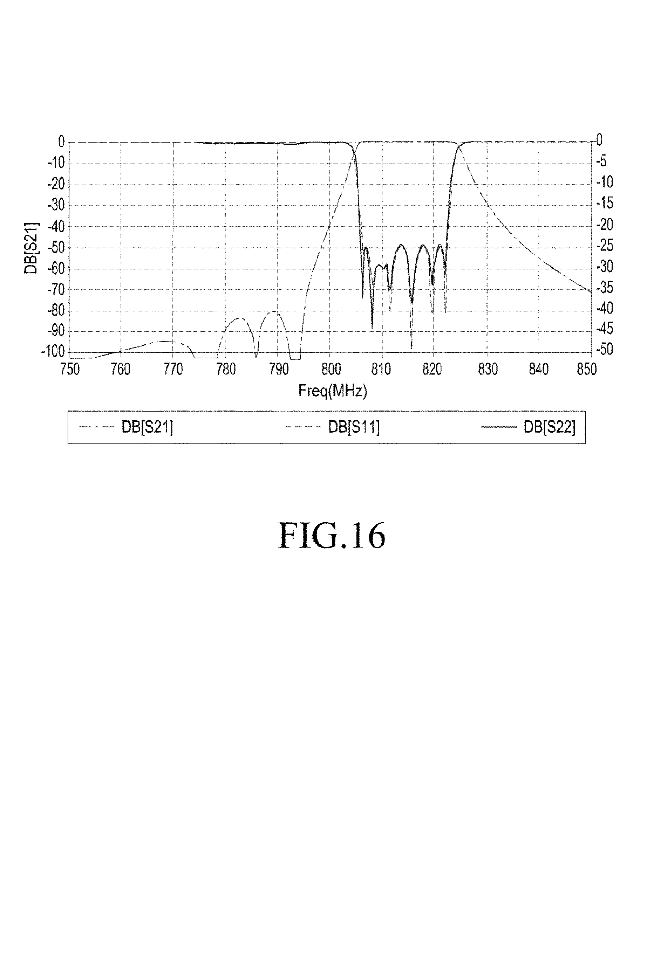

FIG. 15 is a circuit diagram illustrating a radio frequency filter according to a sixth embodiment of the present invention, and FIG. 16 is a waveform diagram illustrating a filtering characteristic at the time of operation according one embodiment of FIG. 15 and shows a waveform when a switching operation of the switching unit 20 is in an on state. Referring to FIGs. 15 and 16, a circuit of a radio frequency filter illustrated in FIG. 15 is mostly identical to a circuit illustrated in FIGs. 10 and 13, but a structure in which the switching unit 20 is formed in a third resonance terminal is just illustrated. In this case, it can be understood that a filtering characteristic is the best.

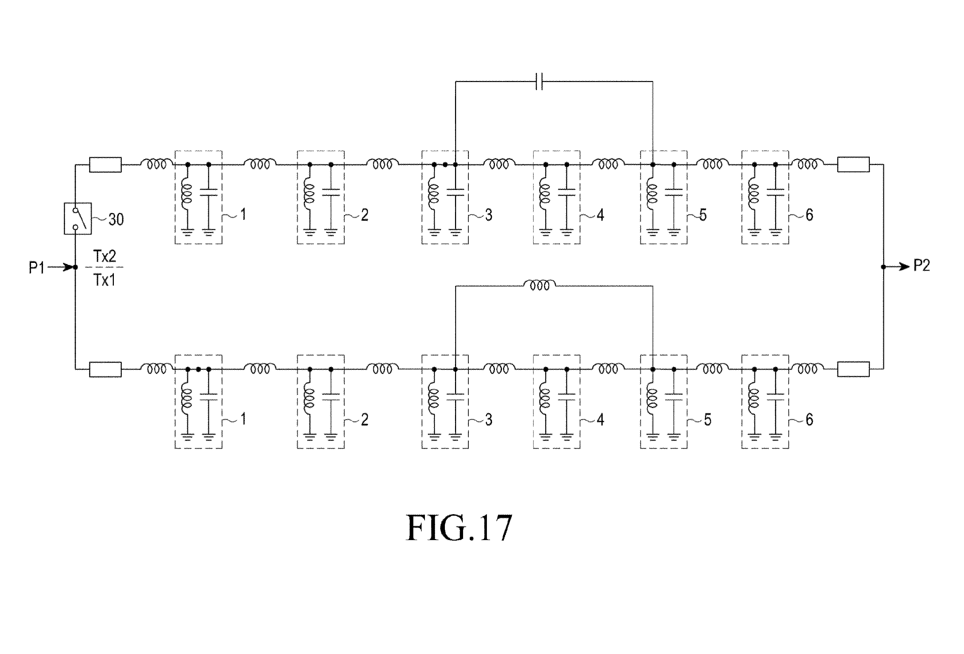

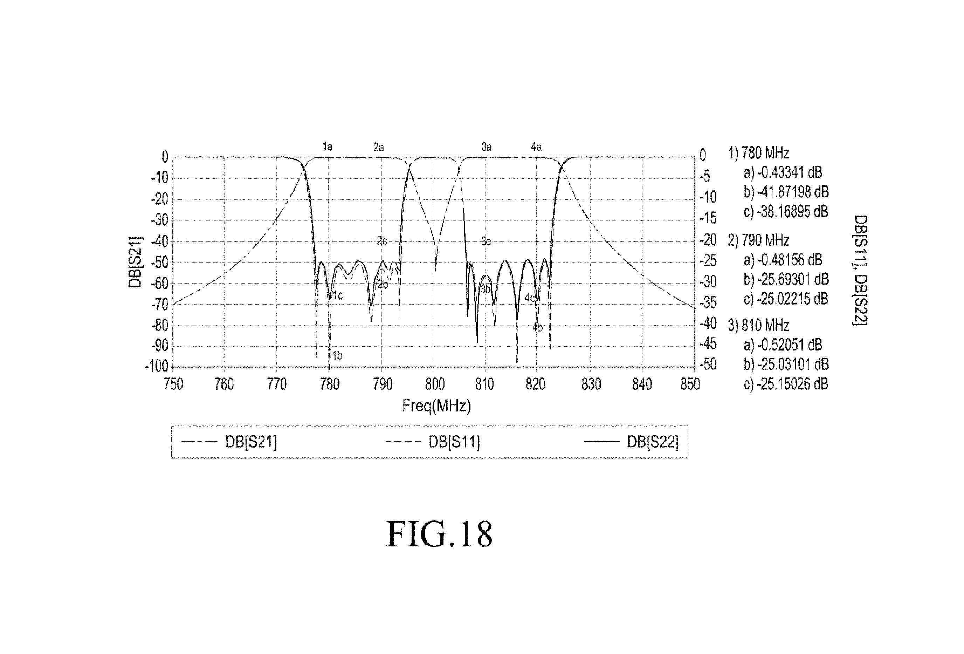

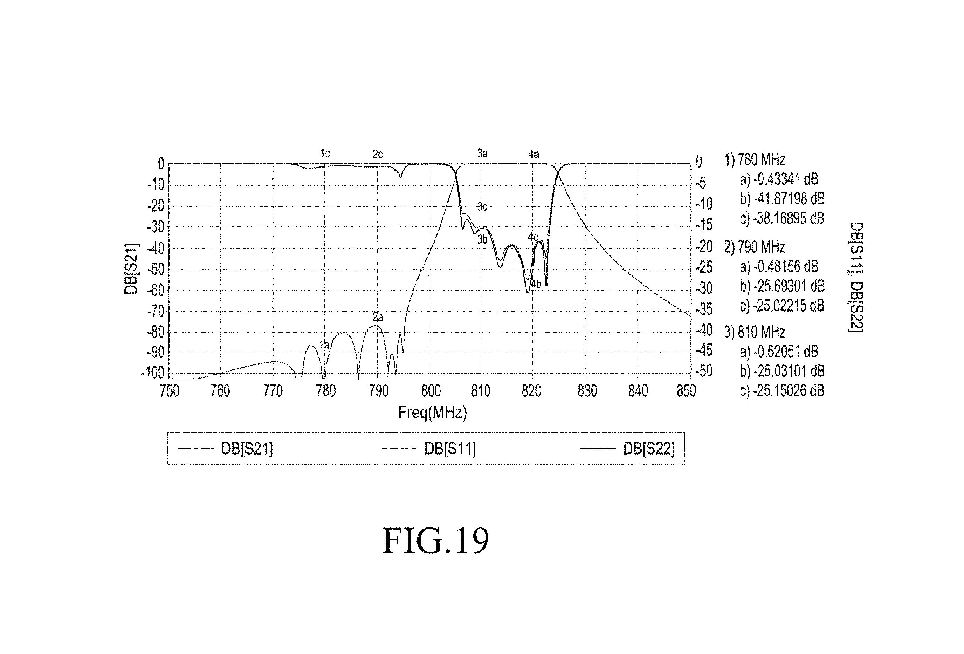

FIG. 17 is a circuit diagram illustrating a radio frequency filter experimentally implemented for comparing the present invention with embodiments, FIG. 18 is a waveform diagram illustrating a filtering characteristic at the time of operation according to one embodiment of FIG. 17 and shows a waveform when a switching operation of a switching unit 30 is in an on state, and FIG. 19 is a waveform diagram illustrating a filtering characteristic at the time of operation according to another embodiment of FIG. 17 and shows a waveform when a switching operation of the switching unit 30 is in an on state. Referring to FIG. 17, a circuit of a radio frequency filter illustrated in FIG. 10, for example, may be a circuit similarly corresponding to a structure of a combiner type illustrated in FIG. 2A. Unlike a structure illustrated in FIG. 2A, FIG. 17 illustrates a configuration of the switching unit 30 connecting or blocking a corresponding path to or from a signal path provided to the first transmission filter unit Tx1 side. Such a switching unit 30 may have a switch structure of a general solenoid driving scheme.

In such a structure, as illustrated in FIG. 18, it can be understood that the first filter unit F1 and the second filter unit F2 normally operate when the switching unit 20 is in an off state. By the way, as illustrated in FIG. 19, the second transmission filter unit Tx2 does not operate and only the first transmission filter unit Tx1 operates when the switching unit 30 is in OFF state. But, in the case, it can be understood that a filtering characteristic is very poor.

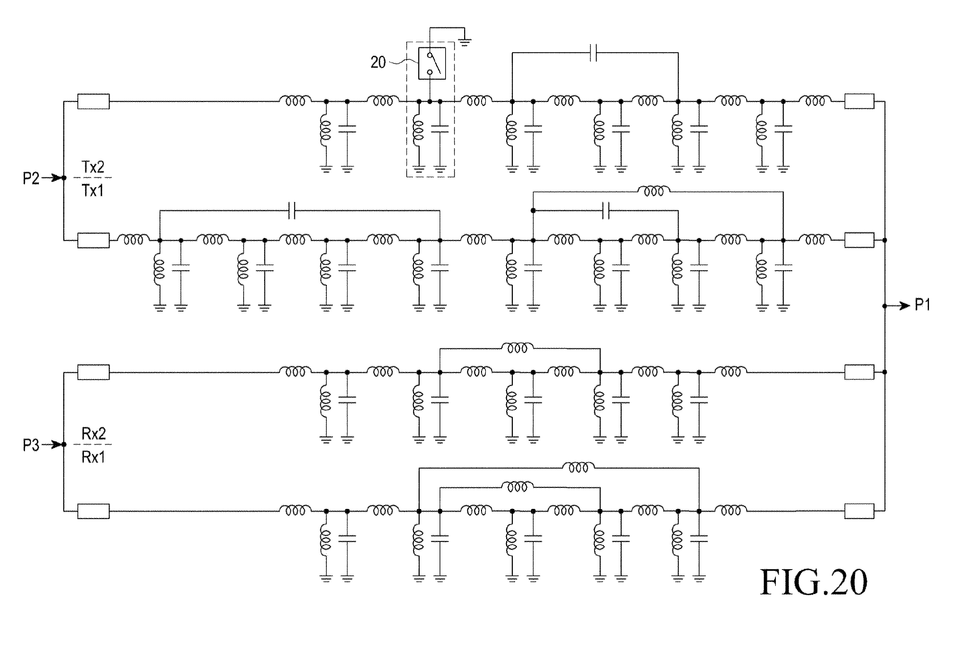

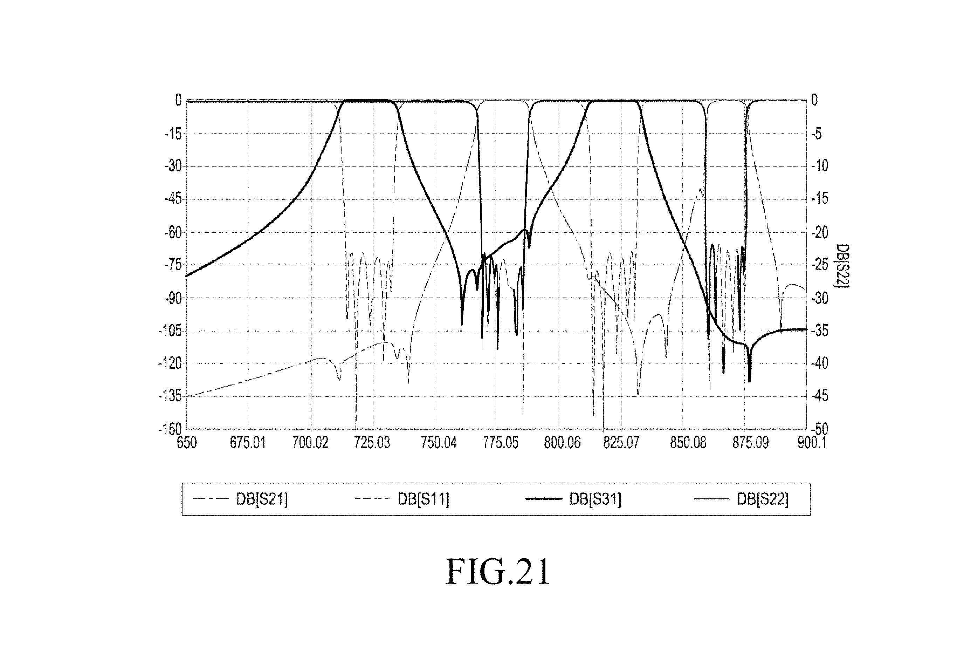

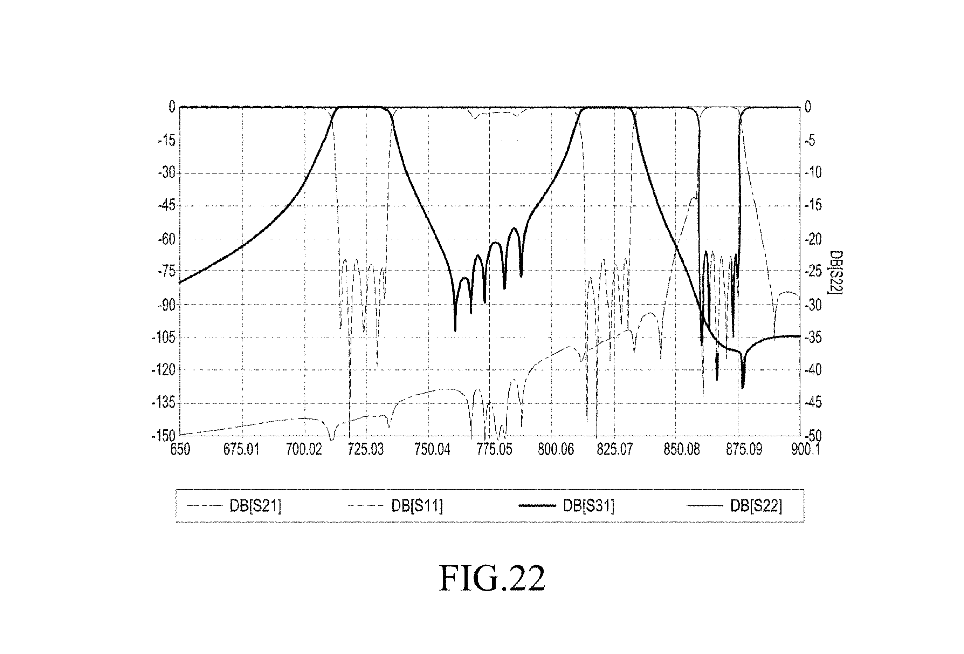

FIG. 20 is a circuit diagram illustrating a radio frequency filter according to a seventh embodiment of the present invention, FIG. 21 is a waveform diagram illustrating a filtering characteristic at the time of operation according to one embodiment of FIG. 20 and shows a waveform when a switching operation of the switching unit 20 is in an off state, and FIG. 22 is a waveform diagram illustrating a filtering characteristic at the time of operation according to another embodiment of FIG. 20 and shows a waveform when a switching operation of the switching unit 20 is in an on state. Referring to FIG. 20, a circuit of a radio frequency filter illustrated in FIG. 20, for example, may similarly correspond to a structure illustrated in FIG. 2B and may be a circuit which can be configured at the time of implementation of an actual circuit of the radio frequency filter 10. In FIG. 20, a structure in which the switching unit 20 is formed in a second resonance terminal of the second transmission filter unit Tx2 from among the four filter units Tx1, Rx1, Tx2 and Rx2 is illustrated. The center frequency of the passband of the second transmission filter unit Tx2 may be designed to be about 770-785 MHz.

In this case, as illustrated in FIG. 21, it can be understood that all of the four filter units Tx1, Rx1, Tx2 and Rx2 normally operate when the switching unit 20 is in an off state. Unlike the above-mentioned description, as illustrated in FIG. 22, it can be understood that the second transmission filter unit Tx2 does not operate and the rest of the filter units Tx1, Rx1 and Rx2 only operate when the switching unit 20 is in an on state.

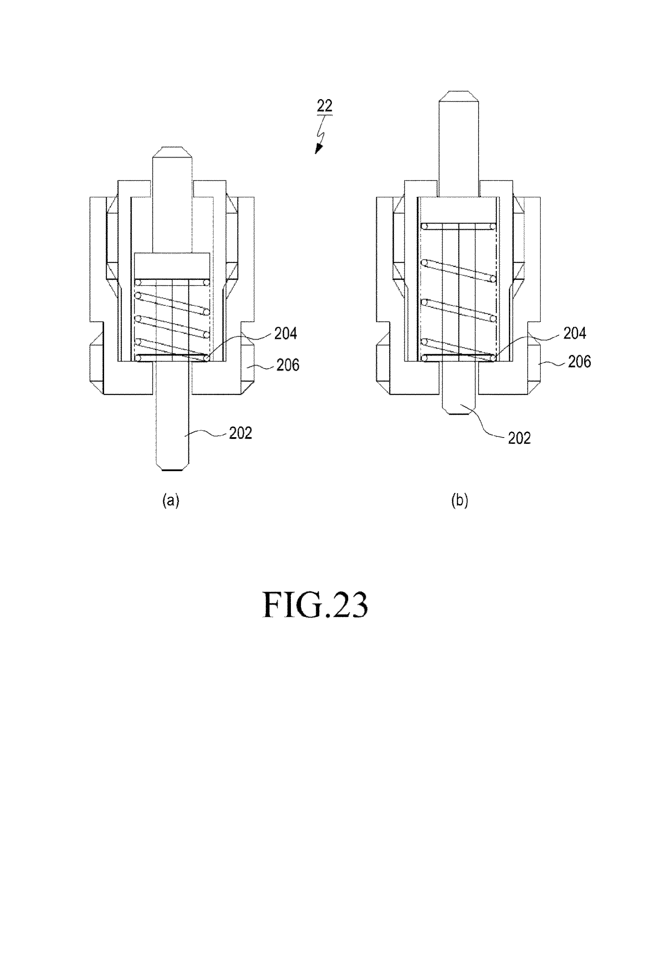

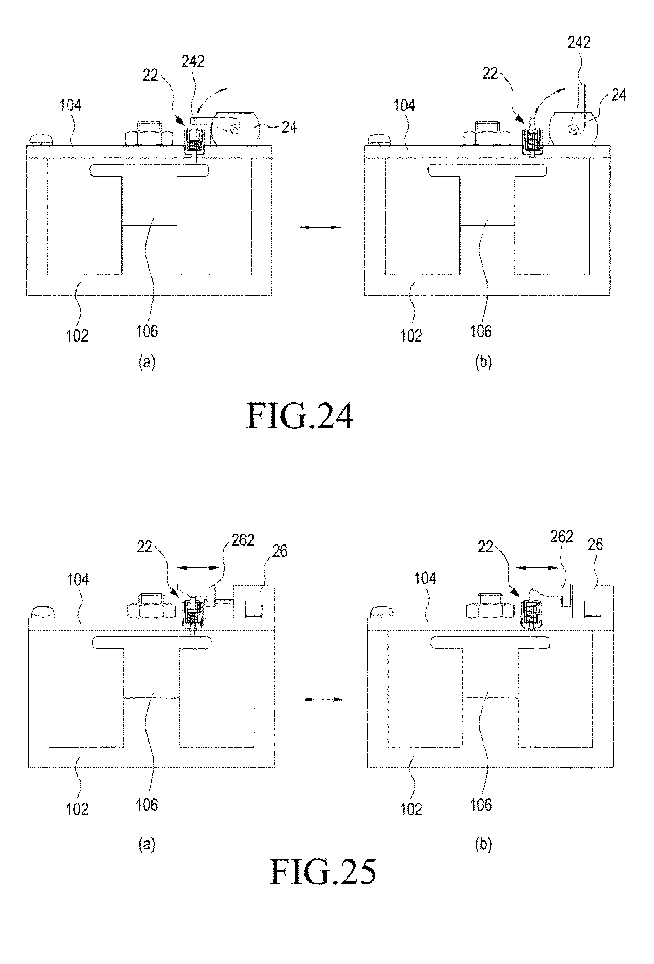

FIG. 23 is a structure diagram illustrating a first example of a switching terminal capable of being applied to a switching unit according embodiments of the present invention, FIG. 23A shows when a switching terminal 22 is in an on state, and FIG. 23B shows when the switching terminal 22 is in an off state. FIG. 24 is a structure diagram illustrating a first example of a driver 24 for driving a switching terminal of FIG. 23, and main parts of a filter relating to the driver 24, and illustrates a state in which the switching terminal 22 is installed on the cover 104 of a radio frequency filter. FIG. 24A shows when the switching terminal 22 is in an on state, and FIG. 24B shows when the switching terminal 22 is in an off state.

Referring to FIGs. 23 and 24, a switching unit according to one embodiment of the present invention includes: the switching terminal 22 having a switching pin 202 designed to be movable to be inserted into the interior of a cavity or to be drawn out to the outside of the cavity and electrically connected to a resonance element 106 to connect the resonance element 106 to a ground terminal when the switching pin is inserted into the interior of the cavity; and the driver 24 for moving the switching pin 202 by an exterior control signal.

Also, the switching terminal 22 may further includes: an elastic body 204 for providing restoring force to restore the switching pin to an initial location thereof; and a case 206 for entirely surrounding and supporting the switching pin 202 and the elastic body 204, wherein the switching terminal 22 may be installed using a scheme in which the case 206 is coupled to a through hole arranged in a proper position of the cover 104 of a filter through a screw coupling structure.

The driver 24 has a motor for generating a driving force by an exterior control signal as a main configuration, and includes a push mechanism 242 which is driven by a driving force of the motor and moves the switching pin 202 in the form of pushing the switching pin 202. As illustrated in FIG. 24, the push mechanism 242 may have a structure in which the push mechanism 242 rotatably moves in arcs in a direction of up-and-down from an upper portion of the switching pin 202 so as to push a protruding upper end of the switching pin 202 when a motor is driven.

Meanwhile, FIG. 24 illustrates an internal structure of one resonance terminal of a radio frequency filter, wherein the radio frequency filter implements one or more internal spaces, that is, a cavity through a housing 102, and has a structure in which a resonance element 106 is installed in each cavity and the housing 10 is sealed by the cover 104. In a radio frequency filter 20 having such a structure, the spring terminal 22 and the driver 24 may be installed in the cover 104.

The resonance element 106, for example, may be made of the metallic resonance element 106 in the form of a metal rod. In this case, the switching pin 20 of the switching terminal 22 is made of a metallic material and has a structure for directly contacting an upper end of the resonance element 106 to connect the resonance element 106 to a ground terminal when the switching pin 20 is inserted into the interior of a filter.

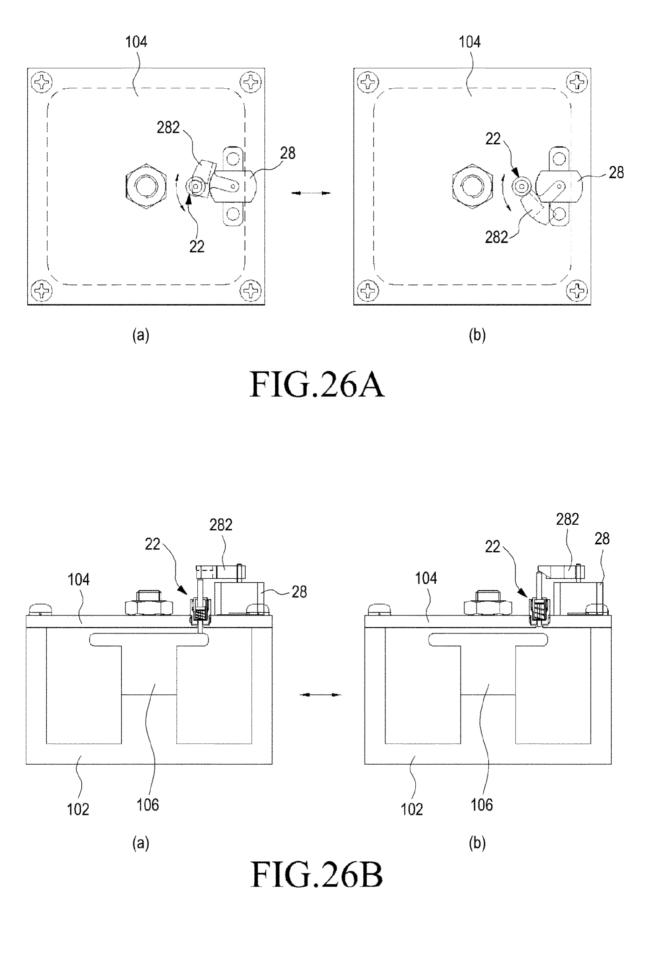

FIG. 25 is a structure diagram illustrating a second example of a driver for driving a switching terminal of FIG. 23, and main parts of a filter relating to the driver, FIG. 25A shows when the switching terminal 22 is in an on state, and FIG. 25B shows when the switching terminal 22 is in an off state. The switching terminal 22 and the installation structure thereof, which are illustrated in FIG. 25, are identical to a structure illustrated in FIG. 24, and are just slightly different from a structure of FIG. 26.

That is, in a driver 26 illustrated in FIG. 26, a push mechanism 262 for moving the switching pin 202 in the form of pushing the switching pin 202 may include an inclined surface in contact with an upper end of the switching pin 202, and may have a structure in which the push mechanism 262 moves to a switching pin 202 side in a straight line from a side surface of the switching pin 202 so as to slide and push the upper end of the switching pin 202 by the side surface when a motor is driven.

FIGs. 26A and 26B are structure diagrams illustrating a third example of a driver for driving a switching terminal of FIG. 23, and main parts of a filter relating to the driver, (a) of FIG. 26A and (b) of FIG. 26B show when the switching terminal 22 is in an on state, and (b) of FIG. 26A and (b) of FIG. 26B show when the switching terminal 22 is in an off state. The switching terminal 22 and the installation structure thereof, which are illustrated in FIG. 25, are identical to a structure illustrated in FIG. 24, and are just slightly different from a structure of FIG. 28.

That is, in a driver 28 illustrated in FIG. 26, a push mechanism 282 for moving the switching pin 202 in the form of pushing the switching pin 202 may include an inclined surface in contact with an upper end of the switching pin 202, and may have a structure in which the push mechanism 282 rotatably moves to a switching pin 202 side in arcs from a side surface of the switching pin 202 so as to slide and push the upper end of the switching pin 202 by the side surface when a motor is driven.

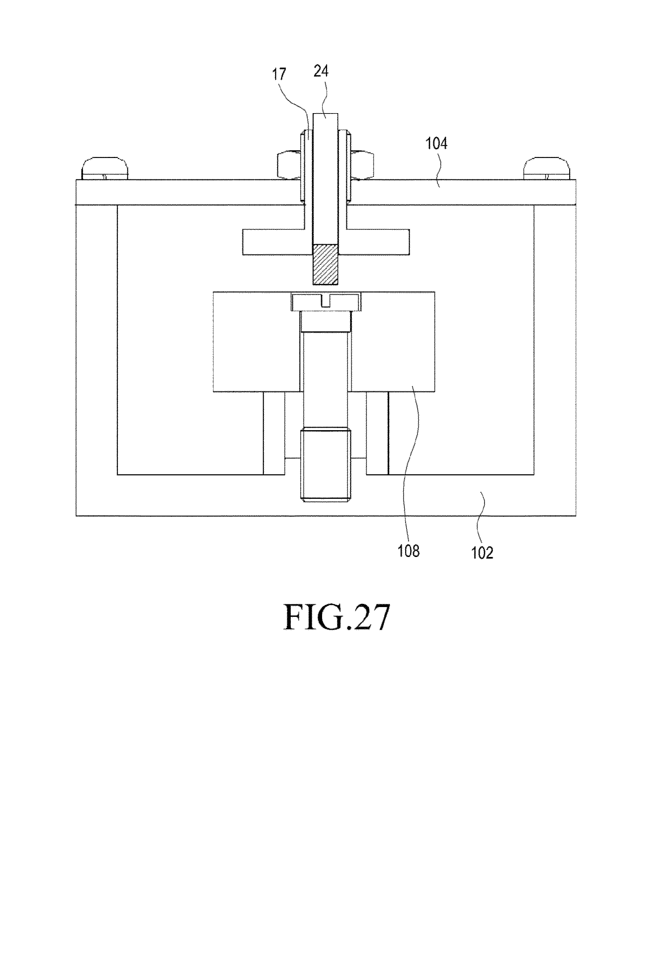

FIG. 27 is a structure diagram illustrating a second example of a switching terminal and main parts of a filter relating to the switching terminal, which may be applied to a switching unit according to embodiments of the present invention, and shows a configuration of the switching terminal when a resonance element 108 is a DR. In this case, a switching pin 26 may be made from ferrite. In this case, the switching pin 20 of the switching terminal 22 is located close to an upper end of the resonance element 108 to eliminate a resonance function when the switching pin 20 of the switching terminal 22 is inserted into the interior of a filter. In FIG. 27, a structure in which the switching pin 26 is inserted into the interior of a filter through a through hole of a tuning screw 17, which is configured in the form of a hollow, is illustrated as an example. An example of such a structure for eliminating a resonance function of a resonance terminal using the switching pin 26 made from ferrite is disclosed in Korean Patent Publication No. 10-2009-00535 (entitled "METHOD OF TUNING DIELECTRIC RESONATOR FILTER" and published on May 12, 2009) (inventors: Nam-Shin Park and Don-Yong Lee), which has previously been filed by the present applicant.

A structure for a driver (not illustrated) for moving such a switching pin 26 made from ferrite to the interior of a cavity may be configured like a structure of a driver, which is disclosed in FIGs. 24 to 26B and the like.

As described above, a configuration and an operation of a radio frequency filter according to one embodiment of the present invention may be achieved. Meanwhile, although specific embodiments are described in the description of the present invention mentioned above, various modifications may be conducted without departing from the scope of the present invention.

For example, in the above-mentioned description, which is a description of a configuration of the first and second transmission and reception filters that may be applied to a base station system, the fact that a switching unit is applied to a second transmission filter unit Tx2 side according to a characteristic of the present invention and the switching unit is not configured in the second reception filter unit Rx2 is described as an example. However, this is because the reception signal is filtered when being processed by the corresponding base station system and it is thus unnecessary to intentionally block the operation of the second reception filter unit Rx2. Nevertheless, of course, the second reception filter unit Rx2 may also be configured to have a switching unit applied thereto.

Further, it is recommended to apply the present invention to a radio frequency filter having a cavity structure in the above-mentioned description. However, in addition, the present invention may be applied so that all filters having a circuit structure in which a plurality of resonance terminals is sequentially connected have a structure for connecting a specific resonance terminal to a ground terminal.

Further, the above-mentioned description describes that a switching unit is applied to only one resonance terminal from among a plurality of resonance terminals constituting a specific filter unit. However, in addition, the switching unit may be implemented to be respectively applied to two or more resonance terminals according to cases.

## Claims

1. A radio frequency filter comprising:
a first filter unit that filters a signal of a first frequency band which is a basic frequency band;
a second filter unit that filters a signal of a second frequency band which is an additional frequency band added together with the basic frequency band; and
a switching unit that has a structure for connecting or blocking at least one resonance terminal from among resonance terminal(s) constituting the second filter unit to or from a ground terminal so as to eliminate or maintain the resonance function of the corresponding resonance terminal.

2. The radio frequency filter of claim 1, wherein the second filter unit is configured by having a structure in which a plurality of resonance terminals is sequentially connected to each other in a multi-stage, and
the switching unit is configured to connect a second resonance terminal or a third resonance terminal to a ground terminal.

3. The radio frequency filter of claim 1, wherein the second filter unit has a cavity structure, and
the switching unit includes:
a switching terminal having a switching pin designed to be movable so as to be inserted into the interior of a cavity and to be drawn out to the outside of the cavity and electrically connected to a resonance element to connect the resonance element to a ground terminal when the switching pin is inserted into the interior of the cavity; and
a driver for moving the switching pin by an exterior control signal.

4. The radio frequency filter of claim 3, wherein the resonance element is a metal rod type resonance element, and
the switching pin is made of a metallic material and has a structure for directly contacting an upper end of the resonance element to connect the resonance element to the ground terminal when the switching pin is inserted into the interior of the cavity.

5. The radio frequency filter of claim 4, wherein, the switching terminal further includes:
an elastic body that provides restoring force to restore the switching pin to an initial location thereof; and
a case for entirely surrounding and supporting the switching pin and the elastic body,
wherein the case is coupled to and installed in a through hole arranged on a cover forming a part of the cavity.

6. The radio frequency filter of claim 3, wherein the resonance element is a dielectric resonance element, and
the switching pin is made from ferrite and is configured to be located close to an upper end of the resonance element to eliminate a resonance function when the switching pin is inserted into the interior of the cavity.

7. The radio frequency filter of one of claims 3 to 6, wherein the driver has a motor for generating a driving force by an exterior control signal as a main component, and includes a push mechanism which is driven by a driving force of the motor and moves the switching pin in a form of pushing the switching pin.

8. The radio frequency filter of claim 7, wherein the push mechanism has a structure in which the push mechanism rotatably moves in arcs in a direction of up-and-down from an upper portion of the switching pin so as to push a protruding upper end of the switching pin when the motor is driven.

9. The radio frequency filter of claim 7, wherein the push mechanism includes an inclined surface which comes in contact with an upper end of the switching pin, and has a structure in which the push mechanism moves to the switching pin side in a straight line from a side surface of the switching pin so as to slide and push the upper end of the switching pin by the inclined surface when the motor is driven.

10. The radio frequency filter of claim 7, wherein the push mechanism includes an inclined surface in contact with an upper end of the switching pin, and has a structure in which the push mechanism rotatably moves to the switching pin side in arcs from a side surface of the switching pin so as to slide and push the upper end of the switching pin by the inclined surface when the motor is driven.
